# EUROPEAN PATENT APPLICATION

(11) **EP 1 674 913 A2**
(43) Date of publication of application: **28.06.2006**
(21) Application number: 05028391.0
(22) Date of filing: 23.12.2005
(51) Int. Cl.: G02B 26/08, B81B 3/00

(54) **Scanning micro-mirror package, method for fabricating the same, and optical scanning device employing the same**

(30) Priority: 24.12.2004 KR 2004112470
(71) Applicant: LG ELECTRONICS INC., Seoul 150-721 (KR)
(72) Inventor: Lee, See-Hyung, Suji-gu Yongin-si Gyeonggi-do 448-534 (KR); Yee, Young-Joo, Bundang-gu Seongnam-si Gyeonggi 463-923 (KR); Ji, Chang-Hyeon, Seocho-gu Seoul 137-754 (KR)
(74) Representative: von Hellfeld, Axel

(57) **Abstract**

Disclosed herein are a scanning micro-mirror package for use in optical scanning devices in which micro-mirrors reflect incident beams and modulate the optical path of the reflected beams in response to input signals and a method for fabricating the same. The scanning micro-mirror package comprises a suitable lid having therein a transparent window through which light beams pass and a housing combined with the lid, wherein a micro-mirror is protected from external impacts and conduct its own functions well. The scanning micro-mirror package is applicable to a device which displays or reads image information or data by scanning a light beam emergent from a light source over a predetermined range. Having such a structure, the scanning micro-mirror package allows the micro-mirror to optimally exhibit its optical and mechanical performance in addition to protecting the micro-mirror from external factors which adversely influence the performance. Also, the scanning micro-mirror package can be fabricated in a slim and lightweight form and is applicable to scanning systems employing various types of micro-mirrors, with the expectation that the production cost can be lowered.

## Description

### BACKGROUND OF THE INVENTION

### 1. Field of the Invention

The present invention relates to a scanning micro-mirror package for use in optical scanning devices in which micro-mirrors reflect incident beams and modulate the optical path of the reflected beams in response to input signals, and a method for fabricating the same.

The package and method according to the present invention is applicable to devices which display or read image information or data by scanning a light beam emergent from a light source over a predetermined range, such as laser printers, confocal microscopes, barcode scanners, scanning displays, sensors, etc. Also, the present invention can be applied to optical switch devices as well as scanning devices.

### 2. Description of the Related Art

With recent advances in optical devices, various techniques which use light as a medium for inputting and outputting various information and for information transmission have been on the rise. Of them, there is a method of scanning beams emergent from a light source, as typically illustrated by a barcode scanner or a scanning laser display, although this is in a rudimentary stage.

Depending on the applications thereof, beam scanning techniques are required to vary in scanning speed and range. In conventional beam scanning techniques, various scanning speeds and ranges are achieved mainly by controlling the incident angle of light with regard to a reflection facet of an operational mirror, such as a galvanic mirror or a rotating polygon mirror.

Indeed, a galvanic mirror is suitable for use where a scanning speed from ones to tens of hertz (Hz) is required while ones of kilohertz (kHz) can be achieved with a polygon mirror.

According to the development of related technologies, extensive efforts have been made to apply beam scanning techniques to new devices or to improve the performance of the pre-existing devices having the beam scanning techniques applied thereto. Representative examples thereof include projection display systems, HMDs (head mounted displays) and laser printers, which all show excellent color reproduction in a laser scanning manner.

In the systems where the beam scanning technique of such a high spatial resolution is employed, a scanning mirror is generally provided for allowing a high scanning speed and a large angular displacement or a tilting angle. Where a polygon mirror is used, its angular velocity determines the scanning speed. Generally, the polygon mirror is usually mounted on a motor, so that the scanning speed depends on the rotation speed of the actuator motor. Accordingly, a limited rotation speed of the motor leads to the limitation in increasing the scanning speed and it is difficult to decrease the volume and power consumption of the system due to the motor.

In addition, actuator motors have a fundamental problem of friction noise and contribute to an increase in production cost because their complex structures.

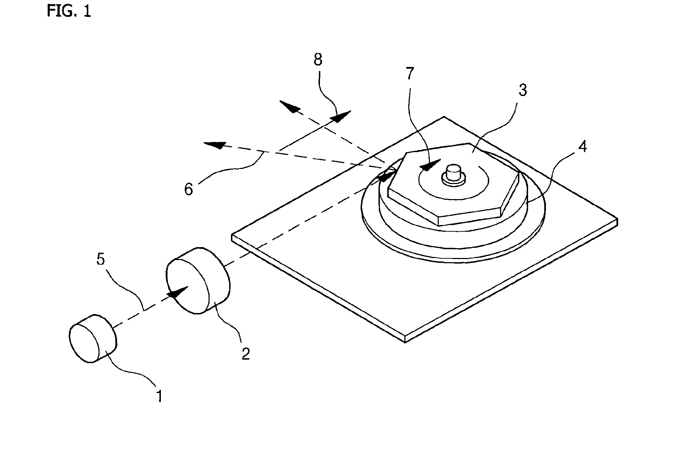

With reference to FIG. 1, a conventional scanning apparatus employing a polygon mirror is schematically shown. In the scanning apparatus, as shown in FIG. 1, a beam 5 emergent from a light source 1 travels through an optical unit 2 including various lenses and is reflected by a polygon mirror 3. As the polygon mirror 3 is rotated by the motor 4, the reflected beam can be scanned in the direction 8 defined by the rotating direction 7 of the polygon mirror 3.

Able as it is to scan at a rather high speed in mono-directionally, a scanning apparatus employing the polygon mirror 3 is inadequate for high resolution displays.

As for a micro-mirror, it allows the scanning apparatus to scan bi-directionally and at a high speed of tens of KHz. In order to perform large bi-directional scans at a high speed, micro-mirrors with a high Q-factor must resonate or be operated in a vacuum atmosphere. In addition, ranging in size from ones of micrometers to ones of millimeters, micro-mirror devices are required to be blocked from external air and impurities and protected from external impacts. Further, the micro-mirrors need to be packaged in such a suitably structural housing as to effectively dissipate the heat of the light source.

In order to achieve beam scanning using the micro-mirrors which operate in a closed package, a transparent window must be provided in a lid located at an upper side of the package. Accordingly, it is necessary to fabricate a lid having a suitable structure and to properly combine the lid with the housing, thereby sealing the package.

### SUMMARY OF THE INVENTION

With the prior art problem in mind, the present invention has an object of providing a scanning micro-mirror package comprising a suitable lid having therein a transparent window through which light beams pass and a housing combined with the lid, wherein a micro-mirror is protected from external impacts and conduct its own functions well, and a method for fabricating the same.

It is another object of the present invention to provide an optical scanning device in which electromagnetically operating micro-mirrors are integrated.

It is a further object of the present invention to provide a scanning micro-mirror package which can contribute to the lightness and slimness of an optical scanning device which is fabricated by a continuous semiconductor process and micromachining technique.

The above objects could be accomplished by a provision of a scanning micro-mirror package, comprising: a housing, onto an inner bottom of which a micro-mirror die is attached, said micro-mirror die being provided for installing a scanning micro-mirror for reflecting an incident light beam thereon; and a lid, combined with the housing, to form an internal space therebetween.

Preferably, the lid comprises a transparent window through which light beams, whether incident upon or reflected from the scanning micro-mirror, pass, and a lid frame in which the window is installed.

The lid and the housing are preferably bonded to each other via a sealing ring to assure a hermetic sealing of the internal space to be formed therebetween.

In a preferred modification, the lid frame has a form of a cap and the housing has a form of a plate.

In another preferred modification, the lid is comprised entirely of a transparent window through which light beams, whether incident upon or reflected from the scanning micro-mirror, pass.

In accordance with another aspect of the present invention, a method is provided for fabricating a scanning micro-mirror package, comprising: bonding a lid to a housing, said lid having a through-hole formed therein; melting a sealant in the through-hole by heating; and solidifying the sealant.

In accordance with a further aspect of the present invention, a method is provided for fabricating a scanning micro-mirror package, comprising: bonding a lid to a housing, said housing having a pipe formed at a predetermined position thereof; and closing the pipe by pressing.

In accordance with still a further aspect of the present invention, a method is provided for fabricating a scanning micro-mirror package, comprising: bonding a lid to a housing, at a predetermined position of which a pipe is formed, said pipe having a cavity formed therein; melting a sealant in the cavity by heating; and solidifying the sealant.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a perspective view showing a scanner using a conventional polygon mirror;
FIG. 2 is a perspective view a one-dimensional scanning system using a scanning micro-mirror;
FIG. 3 provides cross sectional views and a plan view, showing a scanning micro-mirror package in accordance with a preferred embodiment of the present invention;
FIG. 4a is a cross sectional view showing a scanning micro-mirror package in accordance with a first embodiment of the present invention;
FIG. 4b is a cross sectional view showing a scanning micro-mirror package in accordance with a second embodiment of the present invention;
FIG. 4c is a cross sectional view showing a scanning micro-mirror package in accordance with a third embodiment of the present invention;
FIG. 4d is a cross sectional view showing a scanning micro-mirror package in accordance with a fourth embodiment of the present invention;
FIG. 5a provides a plan view and a cross sectional view before a scanning micro-mirror package according to a fifth embodiment of the present invention is sealed;
FIG. 5b is a cross sectional view after a scanning micro-mirror package according to a fifth embodiment of the present invention is sealed;
FIG. 6a provides a plan view and a cross sectional view before a scanning micro-mirror package according to a sixth embodiment of the present invention is sealed;
FIG. 6b is a cross sectional view after a scanning micro-mirror package according to a sixth embodiment of the present invention is sealed.
FIG. 7a is a cross sectional view before a scanning micro-mirror package according to a seventh embodiment of the present invention is sealed;
FIG. 7b is a cross sectional view after a scanning micro-mirror package according to a seventh embodiment fo the present invention is sealed; and
FIG. 8 provides a cross sectional and a plan view showing a scanning micro-mirror package in accordance with an eighth embodiment of the present invention.

### <description of numerals in the drawings>

- 1:: Light source
- 2:: Optical unit
- 3:: Polygon mirror
- 4:: Motor
- 5:: Incident light
- 6:: Reflected light
- 7:: Rotating direction of motor
- 8:: Scanning direction
- 9:: Scanning micro-mirror
- 10:: Reflected light
- 11,111,112,113,114,115,116,117:: Housing
- 12,121,122,123,124,125,126,127:: Pin
- 13,131,132,133,134,135,136,137:: Insulator
- 14,146:: Pipe
- 15, 16:: Cavity
- 17:: Alignment groove
- 18:: Reservoir
- 19:: Heat sink
- 20:: Lid
- 21,211,212,213,214,215,216,217:: Lid frame
- 22,221,222,223,224,225,226,227:: Window
- 23:: Through-hole
- 31:: Micro-mirror die
- 32:: Bonding pad
- 41:: Bonding wire
- 51,513:: Sealing ring
- 52,525:: Sealant
- 91:: Reflection facet
- 92:: Torsion beam
- 100:: Screen

### DESCRIPTION OF THE PREFERRED EMBODIMENTS

Reference should now be made in detail to the preferred embodiments of the present invention, examples of which are illustrated in the accompanying drawings, wherein like reference numerals refer to like elements throughout. In the following embodiments, the description of well-known functions and structures is omitted if it makes the gist of the present invention unclear. The embodiments are described below in order to explain the present invention by referring to the figures.

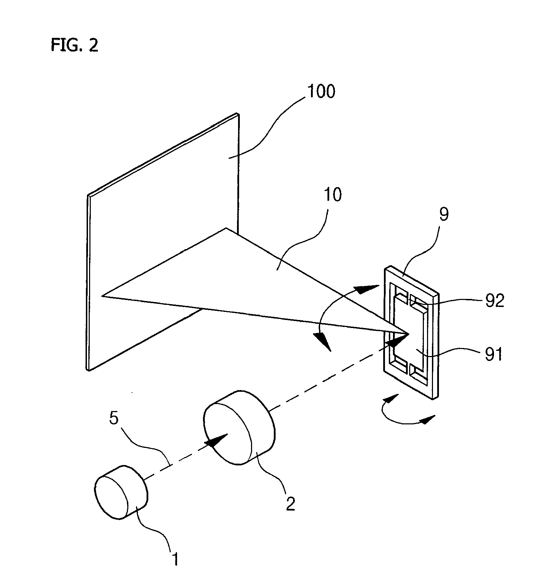

Referring to FIG. 2, a one-dimensional (line) scanning system comprising a scanning micro-mirror is shown in a perspective view.

As shown in FIG. 2, a scanning micro-mirror 9 has a structure such that a reflection face 91 is supported on a torsion beam 92, which functions as a pivot and exerts a restoring torque on the reflection face 91 upon operation. In this structure, the reflection face 91 can do a rotational motion bi-directionally according to input signals.

Hence, when a beam 5 emerging from a light source 1 passes through an optical unit 2, including various lenses, and is incident on the reflection face 91, it is linearly scanned on a screen 100.

A scanning micro-mirror package according to the present invention allows such a beam scanning system to function well.

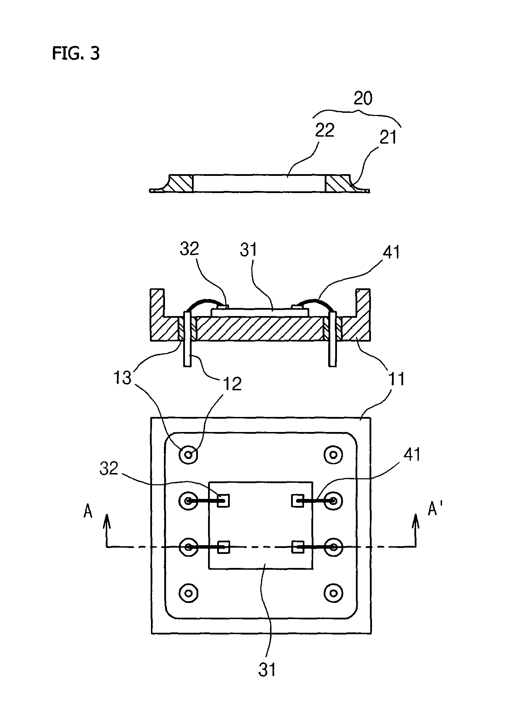

Referring to FIG. 3, a scanning micro-mirror package according to one embodiment of the present invention is shown in a cross sectional view and a plan view. As seen in FIG. 3, the scanning micro-mirror package in accordance with one embodiment of the present invention is largely divided into a housing 11 and a lid 20.

The lid 20 is comprised of a lid frame 21, which determines a general contour of the lid, with a transparent window 22 formed at a predetermined region inside the lid frame.

Because through the transparent window 22, beams are incident on and reflected from the micro-mirror, the transparent window preferably has an anti-reflection coating applied thereon.

Even when the lid frame 21 is made from a material having a high reflective index, its lower sides, which are to form the internal space of the scanning micro-mirror package, are preferably coated with an anti-reflection coating, so as to prevent the occurrence of diffused reflection in the internal space.

Constituting the bottom and walls of the scanning micro-mirror package, the housing has a depression, which provides an internal space when it is combined with the lid 20.

A micro-mirror die 31 is attached onto an inner bottom surface of the housing 11 and wired so as to communicate with the outside. Electrical connection between the micro-mirror die 31 and the outside, as shown in FIG. 3, can be achieved by a bonding wire, which connects a bonding pad 32 formed on the micro-mirror die 31 to a pin 12 formed in the housing 11.

The micro-mirror 9 is attached on the die 31, but is not shown in FIGS. 3 to 8 so as to make the present invention clear.

When the housing 11 is made from an electrically conductive material, an insulator 13 must be interposed between the pin 12 and the housing 11, so that only the pin 12 is allowed to be responsible for the electrical connection to the outside. On the other hand, when the housing 11 is not an electrical conductor, the insulator 13 is not necessary.

Examples of the material for the housing 11 include nickel- or gold-plated metals, such as KOVAR, INVAR, ceramic such as alumina, or polymers.

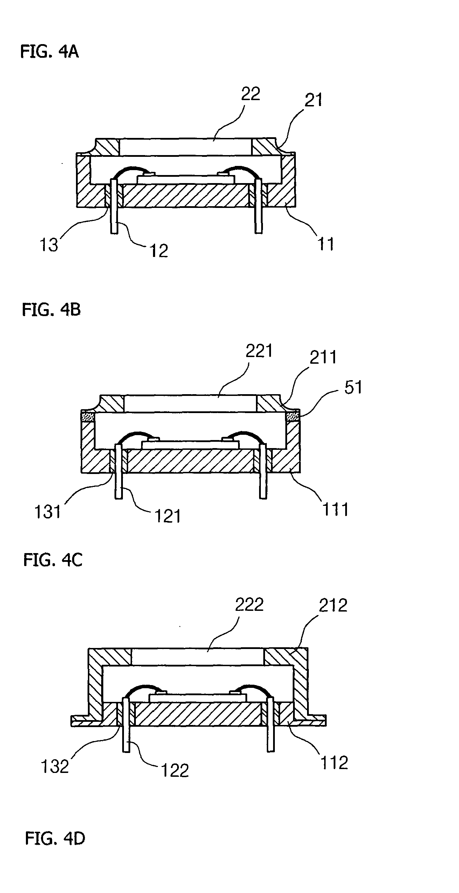

With reference to FIGS. 4a to 4d, structures of the scanning micro-mirror package in accordance with a first to a fourth embodiment of the present invention are shown in cross sectional views, respectively.

FIG. 4a is a cross sectional view after the lid 20 is combined with the housing 11 according to the embodiment of FIG. 3.

The combination of the lid 20 with the housing 11 may be achieved using an adhesive, such as an epoxy sealant.

The adhesive may be applied to the lid 20 and the housing 11 just before the combination or may be, in advance, applied to bonding faces of the lid 20 and the housing 11 when they are fabricated.

When metal constitute the bonding faces of the lid 20 and the housing 11, they can be bonded to each other after a laser beam is scanned over the bonding faces.

FIG. 4b shows a scanning micro-mirror package in accordance with a second embodiment of the present invention, which has the same plate-type lid as in the first embodiment, except that a sealing ring 51 is recruited at the bonding face between a lid frame 211 and a housing 111.

The sealing ring 51 is used to provide hermetic sealing for the inside of the package and made from a low-melting point metal or glass material.

When using the sealing ring 51, the bonding may be accomplished by interposing the sealing ring 51 between the lid and the housing and pressing them against each other while heating the sealing ring.

Alternatively, the low-melting point metal or glass may be, in advance, applied to the bonding face when the lid 211 or the housing 111 is fabricated, followed by heating the sealing ring and pressing the lid or the housing.

FIG. 4c shows a scanning micro-mirror package in accordance with a third embodiment of the present invention, which comprises a plate-type housing 112 and a cap-type lid frame 212.

Except for their general configuration, the housing 112 and the lid frame 212 have the same constitutional elements as those of the first embodiment.

In addition, a sealing ring may be used between the housing 112 and the lid frame 212 so as to achieve hermetic sealing.

FIG. 4d is a cross sectional view showing a scanning micro-mirror package in accordance with a forth embodiment of the present invention, which is similar to that of the second embodiment, with the exception that a lid frame 213 is made totally from a transparent material which is the same as that for the windows 22, 221 and 222 of the first to the third embodiments.

Hermetic sealing, if necessary, may be achieved in all of the embodiments of the present invention. For example, when respective bonding faces of the lid and the housing are comprised of proper metal, seam welding or laser welding may be conducted for hermetic sealing after the lid is brought into direct contact with the housing, as in the first or third embodiment of the present invention.

On the other hand, where metal does not constitute the lid frame 213 or the bonding faces, a metal film is formed locally on the bonding faces, which are then bonded to each other, with a low-melting point metal or glass interposed as a sealing ring 513 therebetween as in the fourth embodiment of the present invention. This is because low-melting point glass is applicable to both metal and glass surfaces.

Further, the internal space of the package may be filled with a predetermined gas, such as nitrogen or helium, upon hermetic sealing.

In the case where vacuum sealing is conducted to maintain the internal space of the package in a vacuum state, the lid may be bonded onto the housing in the same manner as in the hermetic sealing, except that an additional process is used to seal the package in a vacuum atmosphere.

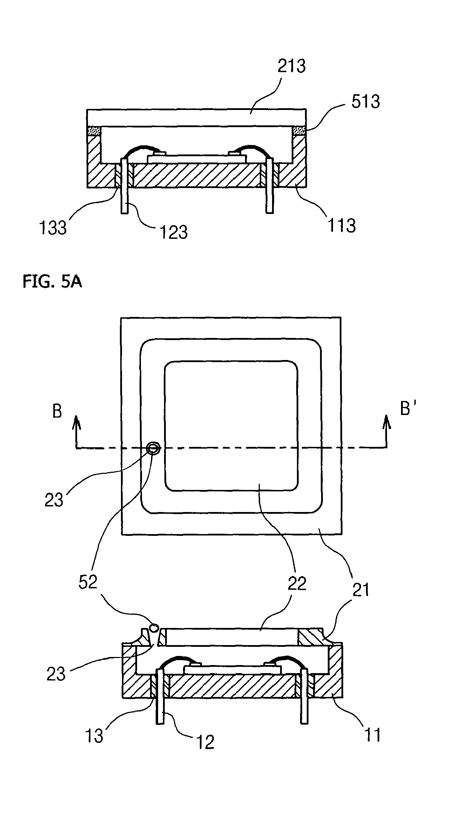

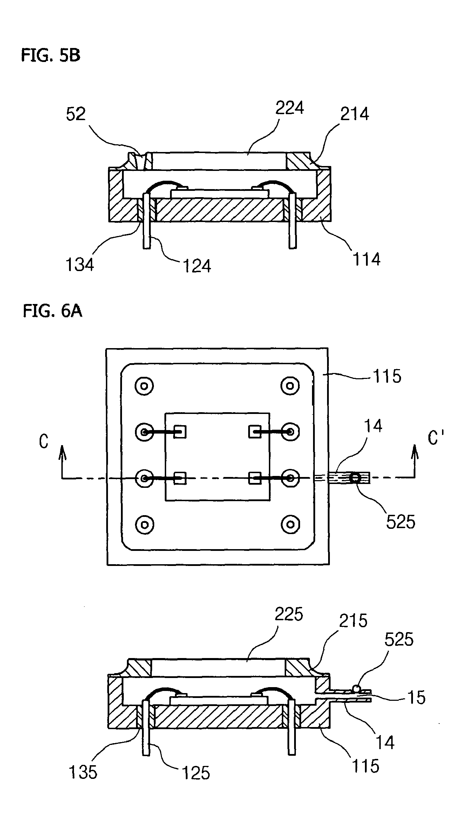

FIGS. 5a and 5b show a scanning micro-mirror package according to a fifth embodiment of the present invention in a plan view and cross sectional views, where a through-hole 23 is used for hermetic sealing.

In the fifth embodiment of the present invention, a through-hole 23 is formed at a predetermined position in a lid frame 214 as shown in FIG. 5a, and the lid frame 214 is bonded to a housing 214 in the same hermetic sealing manner as mentioned above, followed by plugging the through-hole 23 with a sealant 52. In this regard, the sealant 52, made of a low-melting point metal or glass material, is placed in the through-hole 23 and heating is performed at a vacuum pressure to melt the sealant 52, after which the sealant 52 is solidified at a lower temperature to plug the through-hole so as to maintain the internal space in a vacuum state.

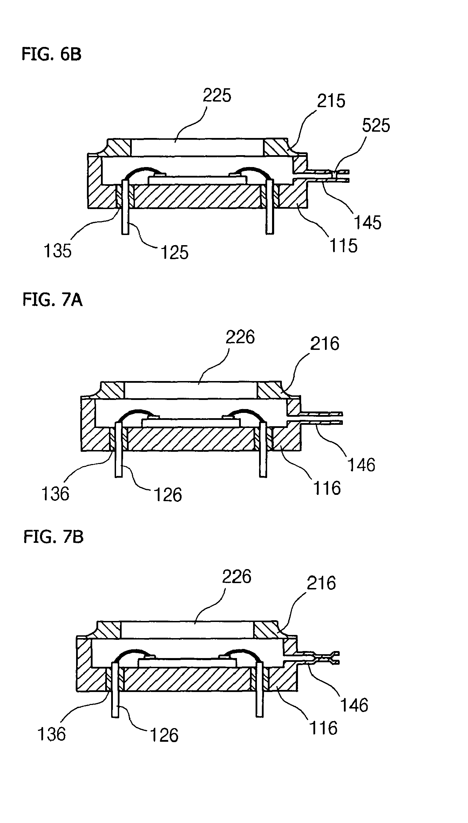

FIGS. 6a and 6b show a scanning micro-mirror package according to a sixth embodiment of the present invention in a plan view and cross sectional views, where a pipe 14 and a pipe cavity 15 are used for hermetic sealing.

In the sixth embodiment, as shown in FIG. 6b, a pipe 14 is provided at a predetermined position of a housing 115 to communicate the outside and the inside of the housing 115, and a cavity 15 to which a sealant is applied is formed at a predetermined position of the pipe 15, as shown in FIG. 6a.

Thereafter, a lid frame 215 is bonded to the housing 115 in a hermetic sealing manner, and a sealant 52 is placed in the cavity 15 and melted by heating at a vacuum pressure.

As the temperature decreases, the molten sealant 52 is solidified, as shown in FIG. 6b, to plug the pipe 14.

FIGS. 7a and 7b show a scanning micro-mirror package according to a seventh embodiment of the present invention, where a pipe 146 alone, not together with a cavity, is used for hermetic sealing.

After a lid frame 216 is bonded to a housing 116, the inside of the scanning micro-mirror package is vacuumed through a pipe provided at a predetermined position of the housing 116 and is sealed by pressing the pipe to a closed state.

In the case of vacuum sealing, a getter is preferably formed at a predetermined position inside the package so as to maintain the inside of the package in a vacuum state.

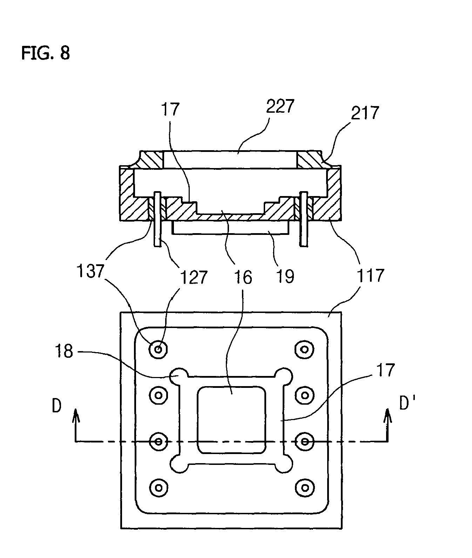

FIG. 8 shows a scanning micro-mirror package in a cross sectional view and a plan view, in which an alignment groove 17 is constructed at a central position on an inner bottom surface of a housing 117 so as to facilitate the attachment of a micro-mirror die thereonto.

In addition, a reservoir 18 may be provided at a predetermined position outside the contour of the alignment groove 17 so as to readily feed a liquid adhesive.

When the gap between the micro-mirror die and the housing 117 is narrow, the micro-mirror is hindered from operating. To prevent this, a cavity 16 may be formed at a position where a micro-mirror die is mounted.

A heat sink 19 may be attached to an outer bottom of the housing 117 or integrated therewith.

The scanning micro-mirror package, along with a light source for generating light beams and an optical unit including at least one lens for converging the light beams on the micro-mirror package, may be used to construct an optical scanning device.

In addition, the optical scanning device may further comprise a macro lens for magnifying the light reflected from the scanning micro-mirror package.

An optical scanning device may be fabricated by installing the scanning micro-mirror package of the present invention, instead of the micro-mirror of FIG. 2.

As described hereinbefore, the scanning micro-mirror package of the present invention is applicable to a device which displays or reads image information or data by scanning a light beam emergent from a light source over a predetermined range.

Having the structures illustrated above, the scanning micro-mirror package of the present invention allows the micro-mirror to optimally exhibit its optical and mechanical performance in addition to protecting the micro-mirror from external factors which adversely influence the performance. Also, the scanning micro-mirror package of the present invention can be fabricated in a slim and lightweight form and is applicable to scanning systems employing various types of micro-mirrors, with the expectation that the production cost can be lowered.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A scanning micro-mirror package, comprising:
a housing onto an inner bottom of which a micro-mirror die is attached, said micro-mirror die being provided for installing a scanning micro-mirror for reflecting an incident light beam thereon; and
a lid, combined with the housing to form an internal space therebetween.

2. The scanning micro-mirror package according to claim 1, wherein the lid comprises a transparent window through which light beams, whether incident upon or reflected from the scanning micro-mirror, pass, and a lid frame in which the window is installed.

3. The scanning micro-mirror package according to claim 2, wherein the transparent window is coated with an anti-reflection coating to prevent the light beams from being reflected from the window.

4. The scanning micro-mirror package according to claim 2, wherein the lid frame has an anti-reflection coating applied on the lower sides thereof to prevent the light beams from undergoing diffuse reflection in an internal space of the scanning micro-mirror package, said lower sides facing the internal space.

5. The scanning micro-mirror package according to claim 1, wherein the housing comprises a bottom and side-walls and has a depression which provides an internal space when it is combined with the lid.

6. The scanning micro-mirror package according to claim 1, wherein a bonding pad is formed on the die, and a pin for electrically communicating with the outside is formed in the housing.

7. The scanning micro-mirror package according to claim 6, wherein the bonding pad is connected via a bonding wire to the pin.

8. The scanning micro-mirror package according to claim 6, wherein the pin is electrically insulated from the housing by an insulator.

9. The scanning micro-mirror package according to claim 1, wherein the housing is made from at least one selected from among plated metal, ceramic, and polymers.

10. The scanning micro-mirror package according to claim 1, wherein the lid is bonded to the housing via an adhesive.

11. The scanning micro-mirror package according to claim 1, wherein the lid and the housing are bonded to each other in a hermetic sealing manner.

12. The scanning micro-mirror package according to claim 11, wherein the lid has a through-hole formed at a predetermined position thereof.

13. The scanning micro-mirror package according to claim 11, wherein a pipe is provided at a predetermined position of the housing to communicate the outside and the inside of the housing.

14. The scanning micro-mirror package according to claim 11, wherein the housing has a getter formed therein.

15. The scanning micro-mirror package according to claim 11, wherein the lid and the housing are bonded to each other via a sealing ring to assure a hermetic sealing of the internal space to be formed therebetween.

16. The scanning micro-mirror package according to claim 15, wherein the sealing ring is made from low-melting point metal or glass.

17. The scanning micro-mirror package according to claim 2, wherein the lid frame has a form of a cap.

18. The scanning micro-mirror package according to claim 17, wherein the housing has a form of a plate.

19. The scanning micro-mirror package according to claim 1, wherein the lid is comprised entirely of a transparent window through which light beams, whether incident upon or reflected from the scanning micro-mirror, pass.

20. The scanning micro-mirror package according to claim 19, wherein the lid and the housing are bonded to each other via a sealing ring to assure a hermetic sealing of the internal space to be formed therebetween.

21. The scanning micro-mirror package according to claim 20, wherein the sealing ring is made from low-melting point metal or glass.

22. The scanning micro-mirror package according to claim 19, wherein the lid has a through-hole formed at a predetermined position thereof.

23. The scanning micro-mirror package according to claim 19, wherein a pipe is provided at a predetermined position of the housing to communicate the outside and the inside of the housing.

24. The scanning micro-mirror package according to claim 19, wherein the housing has a getter formed therein.

25. The scanning micro-mirror package according to claim 1, wherein an alignment groove is constructed at a central position on an inner bottom surface of the housing so as to facilitate the attachment of the micro-mirror die thereonto.

26. The scanning micro-mirror package according to claim 25, wherein a reservoir is provided at a predetermined position outside the contour of the alignment groove so as to readily feed a liquid adhesive.

27. The scanning micro-mirror package according to claim 1, wherein the housing has a heat sink attached to an outer bottom thereof.

28. A method for fabricating a scanning micro-mirror package, comprising:
bonding a lid to a housing, said lid having a through-hole formed therein;
melting a sealant in the through-hole by heating; and
solidifying the sealant.

29. A method for fabricating a scanning micro-mirror package, comprising:
bonding a lid to a housing, said housing having a pipe formed at a predetermined position thereof; and
closing the pipe by pressing.

30. A method for fabricating a scanning micro-mirror package, comprising:
bonding a lid to a housing at a predetermined position of which a pipe is formed, said pipe having a cavity formed therein;
melting a sealant in the cavity by heating; and
solidifying the sealant.
